# EUROPEAN PATENT APPLICATION

(11) **EP 2 228 638 A2**
(43) Date of publication of application: **15.09.2010**
(21) Application number: 10155982.1
(22) Date of filing: 09.03.2010
(51) Int. Cl.: G01N 24/08, G01R 33/563

(54) **MRI method and apparatus for referenceless flow imaging**

(30) Priority: 11.03.2009 US 381349
(71) Applicant: ALLEGHENY-SINGER RESEARCH INSTITUTE, Pittsburgh, PA 15212 (US)
(72) Inventor: Doyle, Mark, Wexford, PA 15090 (US)
(74) Representative: Rees, Simon John Lewis

(57) **Abstract**

An MRI apparatus includes a computer. The MRI apparatus includes imaging coils in communication with the computer that apply imaging gradients and radiofrequency transition pulses to a moving portion of the patient. The MRI apparatus includes detector coils in communication with a computer that obtain a single image component series representing velocity information of the moving portion of the patient in k-space of one cardiac cycle. The MRI apparatus includes a memory in communication with the detector coils in the computer which stores the single image component series. The computer forms an image from the single image component series stored in the memory without any comparison of any image component of the series. A method for using an MRI apparatus with a patient includes the steps of obtaining a single image component series representing velocity information of a moving portion of the patient in k-space of one cardiac cycle with imaging coils and detector coils of the MRI apparatus. There is the step of forming with a computer of the MRI apparatus an image from the single image component series stored in a memory without any comparison of any image component of the series.

## Description

### FIELD OF THE INVENTION

The present invention is related to obtaining a single image component series with an MRI representing velocity information of a moving portion of a patient in k-space of one cardiac cycle. (As used herein, references to the "present invention" or "invention" relate to exemplary embodiments and not necessarily to every embodiment encompassed by the appended claims.) More specifically, the present invention is related to obtaining a single image component series with an MRI representing velocity information of a moving portion of a patient in k-space of one cardiac cycle where a velocity component of phase information on each image component is extracted.

### BACKGROUND OF THE INVENTION

This section is intended to introduce the reader to various aspects of the art that may be related to various aspects of the present invention. The following discussion is intended to provide information to facilitate a better understanding of the present invention. Accordingly, it should be understood that statements in the following discussion are to be read in this light, and not as admissions of prior art.

Others have proposed to extract velocity information from steady-state-free-precession (SSFP) images by noting that phase information is approximately zero for static tissue, and that velocity related phase information can be approximated from each frame by removing the remaining slowly varying phase information relating to non-flow causes. However, these approaches do not attempt to remove the more complex phase disruptions that are characteristic of gradient echo velocity encoded scans. MAGPI can be applied to gradient echo and SSFP images.

### BRIEF SUMMARY OF THE INVENTION

The present invention pertains to an MRI. The MRI comprises a computer. The MRI comprises imaging coils in communication with the computer that apply imaging gradients and radiofrequency transition pulses to a moving portion, such as at least a portion of a moving portion of a cardiovascular system, of the patient. The MRI comprises detector coils in communication with a computer that obtain a single image component series representing velocity information of the moving portion of the patient in k-space of one cardiac cycle. The MRI comprises a memory in communication with the detector coils in the computer which stores the single image component series. The computer forming an image from the single image component series stored in the memory without any comparison of any image component of the series.

The present invention pertains to a method for using an MRI with a patient. The method comprises the steps of obtaining a single image component series representing velocity information of a moving portion, such as at least a portion of a moving portion of a cardiovascular system, of the patient in k-space of one cardiac cycle with imaging coils and detector coils of the MRI. There is the step of forming with a computer of the MRI an image from the single image component series stored in a memory without any comparison of any image component of the series.

### BRIEF DESCRIPTION OF THE SEVERAL VIEWS OF THE DRAWING

In the accompanying drawings, the preferred embodiment of the invention and preferred methods of practicing the invention are illustrated in which:

Figure 1 is an illustration of phase disruption in a typical in-vivo image of the cardiac region.

Figure 2 is an illustration of how phase information can encode velocity information after performing correcting of phase variations using a reference image.

Figure 3 is a time series of k-space data are time series ordered and analyzed by Fourier transforming along the time series.

Figure 4 is a Fourier coefficient series generated from Fourier analysis along the time axis of a series of time-ordered k-space data.

Figure 5 is a flow chart block diagram of the MRI of the present invention.

Figure 6 is a block diagram of the MRI of the present invention.

### DETAILED DESCRIPTION OF THE INVENTION

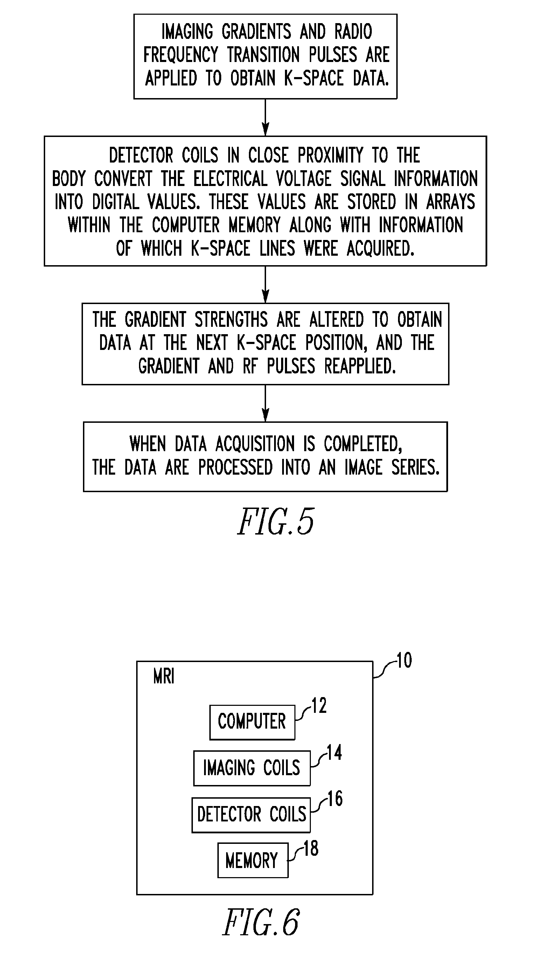

Referring now to the drawings wherein like reference numerals refer to similar or identical parts throughout the several views, and more specifically to figure 6 thereof, there is shown an MRI 10. The MRI 10 comprises a computer 12. The MRI 10 comprises imaging coils 14 in communication with the computer 12 that apply imaging gradients and radiofrequency transition pulses to a moving portion, such as at least a portion of a moving portion of a cardiovascular system, of the patient. The MRI 10 comprises detector coils 16 in communication with a computer 12 that obtain a single image component series representing velocity information of the moving portion of the patient in k-space of one cardiac cycle. The MRI 10 comprises a memory 18 in communication with the detector coils 16 in the computer 12 which stores the single image component series. The computer 12 forms an image from the single image component series stored in the memory 18 without any comparison of any image component of the series.

Preferably, the computer 12 extracts a velocity component of phase information on each image component. The computer 12 preferably uses a magnitude Fourier transform such that no phase information is calculated for each pixel of each image component of the series to create a series of magnitude images from the single image component series. Preferably, the computer 12 uses an inverse Fourier transform on the series of magnitude images to regenerate k-space data as k-space matrices, where the k-space data are idealized representations in that they do not contain any phase information pertaining to velocity.

The computer 12 preferably arranges the original k-space matrices in ascending temporal order and Fourier transforms the k-space matrices along a temporal axis, resulting in a series of Fourier coefficients. Preferably, a zeroth coefficient of the Fourier coefficients represents an average of the series of k-space matrices, and other coefficients of the Fourier coefficients operate on the zeroth coefficient with the computer 12 to form data representing the zeroth coefficient modulated by each frequency represented. The computer 12 preferably applies imaging gradients and radiofrequency transition pulses to the moving portion of the patient to obtain the k-space data.

Preferably, the computer 12 converts electrical voltage signal information from the patient into digital values with the detector coils 16, and storing the digital values along with information regarding which k-space lines were acquired into the memory 18. The computer 12 preferably alters the gradient strengths produced by the imaging coils 14 to obtain data at a next k-space position, and reapplies the imaging gradients and radiofrequency transmission pulses to the moving portion of the patient.

The present invention pertains to a method for using an MRI 10 with a patient. The method comprises the steps of obtaining a single image component series representing velocity information of a moving portion, such as at least a portion of a moving portion of a cardiovascular system, of the patient in k-space of one cardiac cycle with imaging coils 14 and detector coils 16 of the MRI 10. There is the step of forming with a computer 12 of the MRI 10 an image from the single image component series stored in a memory 18 without any comparison of any image component of the series.

Preferably, the forming step includes the step of extracting a velocity component of phase information on each image component. The forming step preferably includes the step of using a magnitude Fourier transform such that no phase information is calculated for each pixel of each image component of the series to create a series of magnitude images from the single image component series. Preferably, the forming step includes the step of using an inverse Fourier transform on the series of magnitude images to regenerate k-space data as k-space matrices, where the k-space data are idealized representations in that they do not contain any phase information pertaining to velocity.

The forming step preferably includes the steps of arranging the original k-space matrices in ascending temporal order and Fourier transforming the k-space matrices along a temporal axis, resulting in a series of Fourier coefficients. Preferably, the Fourier transforming step includes the step of applying the Fourier transform to a time domain of the k-space matrices which generates a series of k-space data, which includes a first zeroth-order Fourier coefficient and higher order Fourier coefficients that contain information relating to a spatial distribution and velocity of the pixels.

The Fourier transforming step preferably includes the steps of applying the Fourier transform to the series of idealized k-space matrices corresponding to each frame of a time series to generate modified k-space coefficient matrices, which includes a second zeroth-order Fourier coefficient and higher order Fourier coefficients.

Preferably, there is the step of replacing the first zeroth-order Fourier coefficient with the second zeroth-order Fourier coefficient, and applying the Fourier transform to ordered composite Fourier coefficients to generate k-space data that are individually Fourier transformed to generate images where the phase of the images represents the velocity data for each pixel.

There is preferably the step of applying imaging gradients and radiofrequency transition pulses to the moving portion of the patient to obtain the k-space data. Preferably, there are the steps of converting electrical voltage signal information from the patient into digital values with the detector coils 16, and storing the digital values along with information regarding which k-space lines were acquired into the memory 18. There are preferably the steps of altering the gradient strengths produced by the imaging coils 14 to obtain data at a next k-space position, and reapplying the imaging gradients and radiofrequency transition pulses to the moving portion of the patient.

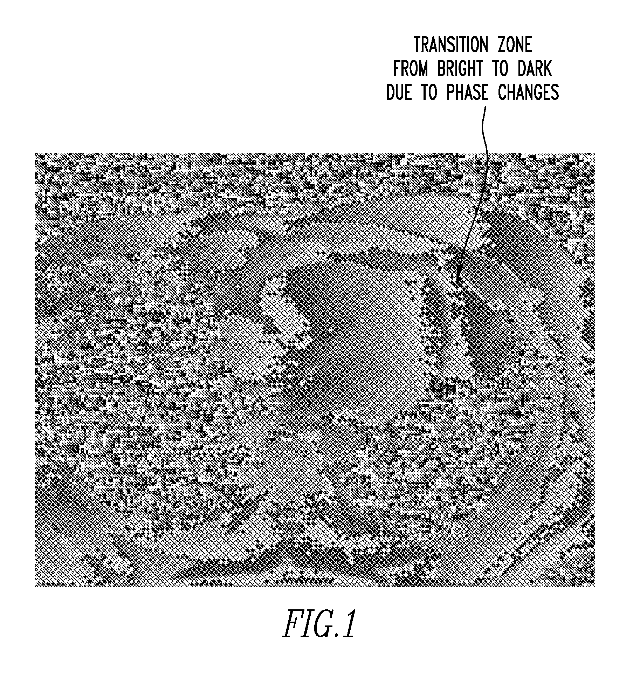

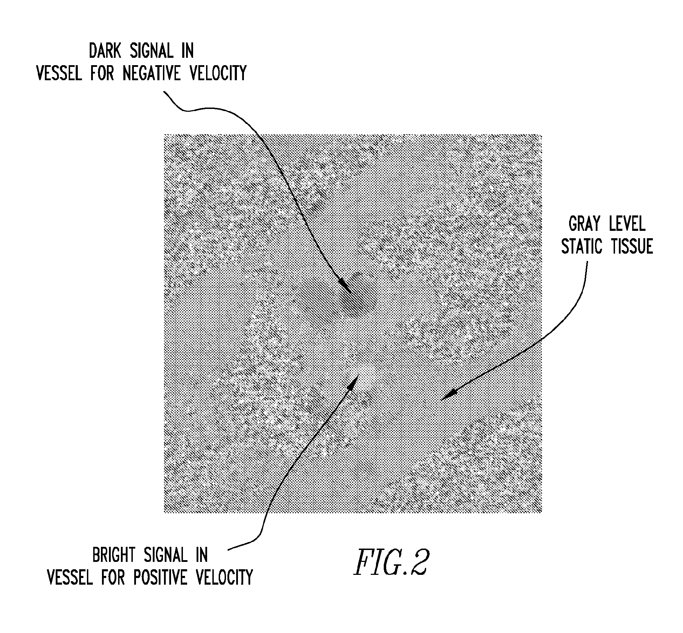

In the operation of the invention, there is described a magnetic resonance imaging (MRI 10) approach to extract quantitative and non-quantitative velocity information from MRI 10 images without requiring use of a reference image. Typically in quantitative velocity imaging by MRI 10 gradients are applied to encode velocity sensitive information into the phase of the image. This phase information can be interpreted to yield quantitative velocity information. However, various factors of the image acquisition process typically contribute additional phase values to each image pixel, and these are responsible for disrupting the phase information, generally making it impossible to unequivocally determine the component of a pixel's phase that is due to velocity of the tissue imaged, Figure 1. Figure 1 is an illustration of phase disruption in a typical in-vivo image of the cardiac region. The phase information experiences multiple transitions from bright to dark signal due to the variations in phase that occur over the image. Thus, it is common practice to additionally obtain a reference image, i.e. one in which velocity is not explicitly encoded, but which is otherwise identical to the velocity encoded image. The phase of each pixel in the reference image is subtracted from the phase of each corresponding pixel in the velocity-encoded image, thereby subtracting out all phase influences not related to velocity, Figure 2. In this way, a "reference" and a "velocity encoded" scan pair are typically required to allow unambiguous extraction of velocity information. Figure 2 is an illustration of how phase information can encode velocity information after performing correcting of phase variations using a reference image. In this example, blood vessels are seen to have bright or dark signal relative to the relatively uniform gray static tissue.

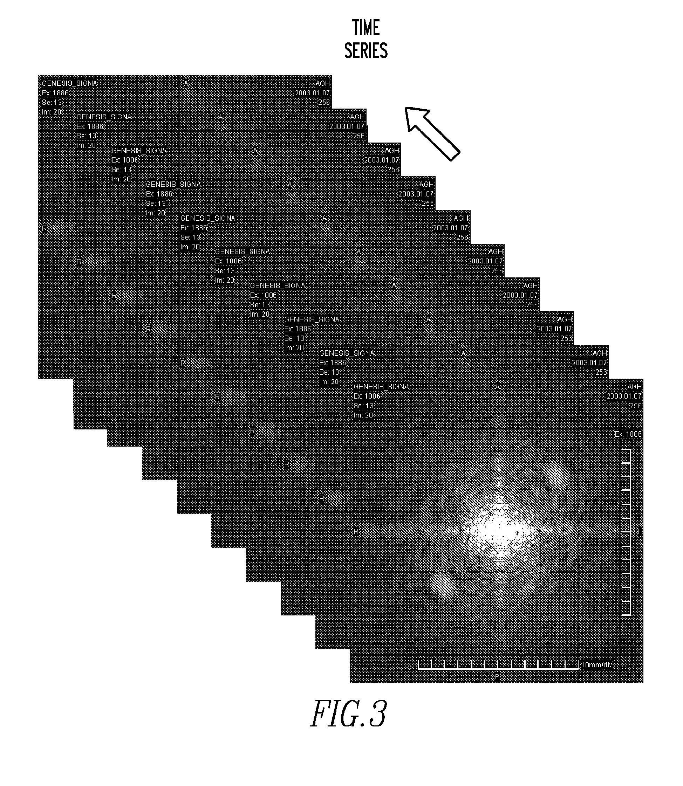

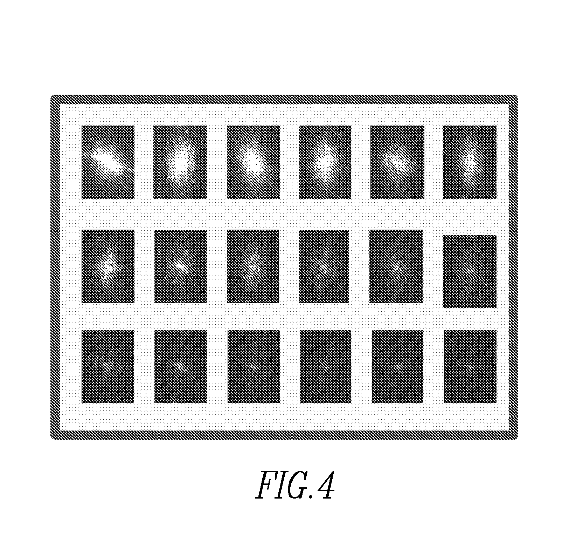

The current invention, Magnitude and Phase Imaging (MAGPI) addresses the issue of extracting the velocity component of phase information without requiring acquisition of a separate "reference" image. In MAGPI the velocity encoded image is acquired for a time-ordered series of images. Firstly, reconstruction is performed using a "magnitude" Fourier Transform, such that no phase information is calculated for each pixel of each image of the time series. The series of magnitude images are then inverse Fourier transformed to regenerate k-space data, but in this instance, the k-space data are "idealized" representations in that they do not contain any phase information pertaining to either velocity or any of the confounding influences. The series of idealized k-space matrices are then arranged in ascending temporal order and Fourier transformed along the temporal axis, Figure 3. Figure 3 is a time series of k-space data that are time series ordered and analyzed by Fourier transforming along the time series. The output of this analysis is a series of Fourier coefficients, Figure 4. Figure 4 is a Fourier coefficient series generated from Fourier analysis along the time axis of a series of time-ordered k-space data. The zeroth coefficient is located at the top left had corner, and the first coefficient is to the right. Shown here are the first 18 coefficients (0-17). The zeroth coefficient represents the average of the series of k-space matrices, and the other coefficients operate on the zeroth coefficient data to form a data series corresponding to the zeroth coefficient values modulated by each frequency represented (i.e. the 2nd coefficient acts on the zeroth coefficient with a sinusoidal and cosinusoidal variation with frequency 2 cycles). Thus, in this instance, the coefficients higher than the zeroth describe how the k-space data physically deform or change contrast over the time series. A separate, but similar analysis is performed using the original series of k-space matrices, which are also arranged in ascending order and Fourier transformed along the temporal axis. The interpretation of these coefficients is similar to the idealized coefficients, with the addition that they also collectively contain the information relating to the velocity and other sources of phase change. In MAGPI the idealized zeroth coefficient is substituted for the zeroth coefficient of the original data, and the Fourier coefficients generated from the original data are made to operate on the "idealized" zeroth coefficient by performing an inverse Fourier transformation along the time time-ordered series of coefficients. The series of data generated by the inverse transform is the time-ordered set of k-space data that are then individually Fourier transformed to form images containing phase information due to velocity, while phase information originating from other effects are largely not present, since this information is largely static in nature (static data are only present in the zeroth coefficient). The velocity related phase information can then be directly extracted from the phase of the hybrid reconstructed image series.

An MRI 10 scanner is utilized to obtain data from a patient. The data are obtained by applying radiofrequency (RF) pulses and imaging gradients in a computer 12 controlled sequence. The combination of RF pulses and gradients encode spatial and velocity information in the raw data which are amplified, digitally sampled, and stored in the memory 18 of a computer 12 system. The data are organized into a series of k-space matrices within the computer 12 memory 18 and storage devices. A data series is acquired, typically triggered to the electrocardiogram (ECG), such that over a single or plurality of cardiac cycles the set of data matrices are ordered progressively throughout the cardiac cycle. Figure 5 is a flow chart regarding the present invention.

In MAGPI the velocity encoded data are acquired for a time-ordered series (typically ordered to the ECG cycle). Following acquisition of the time-ordered data series, the k-space data are transformed into a series of images by application of the mathematical operation of a Fourier Transform and implemented in the computer 12 system. The series of image data are formed into a series of magnitude images, whereby the complex (real and imaginary) values are squared and summed and the square root formed and used for the intensity of each pixel. By this means none of the phase information that was encoded in the original k-space data is preserved. The series of magnitude images thus formed are then converted back into the k-space domain by applying an inverse Fourier transform to each magnitude image of the series. Since the magnitude images did not preserve any of the phase information, it follows that the k-space series generated by the inverse Fourier transform operation also do not contain any information relating to the encoded phase data. In this respect, the k-space data are "idealized" representations in that they do not contain any phase information pertaining to either velocity or any of the confounding influences that affect phase.

Within the computer 12 system, the series of idealized k-space matrices are arranged in ascending temporal order and the mathematical operation of a Fourier transform is applied in the computer 12 along the temporal axis. The output of this analysis is a series of Fourier coefficients which are stored in the computer 12 memory 18. The zeroth coefficient represents the average of the series of k-space matrices, and when entered into the Fourier transform, the higher order coefficients effectively operate on the zeroth coefficient data. These series of operations act on the data of the zeroth coefficient in a manner consistent with the frequency data represented by represented the higher order coefficients (e.g. the 2nd coefficient acts on the zeroth coefficient data to cause an oscillation over the time series with a sinusoidal and cosinusoidal variation with frequency 2 cycles). Thus, the coefficients higher than the zeroth describe how the k-space data physically deform or change in contrast over the time ordered series.

A separate, but similar analysis is performed using the original series of k-space matrices. The original k-space data are arranged in the computer 12 system in the time ordered manner and the mathematical operation of the Fourier transform is applied to the data along the temporal axis. The Fourier coefficients formed by this operation are stored in the memory 18 of the computer 12 system. This series of Fourier coefficients contain information relating to three aspects of the data series 1) spatial position and intensity of image domain pixels, 2) velocity information stored in the phase of the image domain pixels, and 3) distortions of the phase information of the image domain pixels relating to aspects such as magnetic field inhomogeneity and susceptibility.

Following generation of the two series of Fourier coefficients, the idealized zeroth coefficient is substituted in the computer 12 memory 18 for the zeroth coefficient of the original data. Using the hybrid (idealized and original) series of coefficients the inverse Fourier transform process is performed in the computer 12 system to generate a time-ordered series of k-space matrices. Each of the k-space matricides are individually Fourier transformed to form image data containing phase information primarily related to velocity information, while phase information originating from other effects are largely eliminated, since this information is largely static in nature (static data are present in the zeroth coefficient). The series of images generated at this step are represented in complex number format, and the velocity data are extracted from the phase information of each image pixel. The velocity information can be represented in image format using a display convention whereby zero velocity is a mid-level gray value, positive velocities are brighter than this, and negative velocities are lower in intensity.

Applications of MAGPI include extracting velocity from scans specifically designed to encode velocity information, , the velocity encoded direction is not constrained to only one direction such as thorough plane, since it allows in-plane velocities to be extracted. The cardiovascular system is the largest area of interest, but anywhere in the body of the patient where velocity is encoded and used would be applicable (such as flow of cerebral spinal fluid in the brain). The Cardiovascular system comprises the heart, arteries, veins, and valves. The heart muscle (myocardium) moves over the cardiac cycle, and can thus be tracked directly using velocity imaging, the blood cyclically moves through the arteries, and can thus be tracked over the cardiac cycle, and blood returns to the heart in the veins, in a less pulsatile, steady flow manner, again suitable for evaluation with velocity imaging. Certain regions may be of more interest to the physician such as the aorta (ascending, arch and descending), pulmonary veins, renal arteries, and myocardial motion over the full cardiac cycle. Other applications to the cardiovascular system include evaluation of shunts, where blood does not move along the expected path, but is shunted from the arterial side to the venous side (or vice versa). In this case, the severity of the shunt can be evaluated using velocity imaging. Also, valves that should close to stop blood from returning to the heart or vasculature can sometimes malfunction, and evaluating velocity of blood through the faulty valve is of great importance. Sometimes a foreign body or mass is present in the blood, such as a tumor, and evaluating its motion as it is moved by the blood using velocity imaging is important.

One of the key features of the MAGPI scheme is it does not require acquisition of a reference phase image, it does not require that velocity be known in any given frame to act as a reference for other frames, and it takes into account the phase changes associated with motion and deformation of the imaged region.

Although the invention has been described in detail in the foregoing embodiments for the purpose of illustration, it is to be understood that such detail is solely for that purpose and that variations can be made therein by those skilled in the art without departing from the spirit and scope of the invention except as it may be described by the following claims.

## Claims

1. A method for using an MRI with a patient comprising the steps of:
obtaining a single image component series representing velocity information of a moving portion of the patient in k-space of one cardiac cycle with imaging coils and detector coils of the MRI; and
forming with a computer of the MRI an image from the single image component series stored in a memory without any comparison of any image component of the series.

2. The method as described in Claim 1 where in the forming step includes the step of extracting a velocity component of phase information on each image component.

3. The method as described in Claim 2 wherein the forming step includes the step of using a magnitude Fourier transform such that no phase information is calculated for each pixel of each image component of the series to create a series of magnitude images from the single image component series.

4. The method as described in Claim 3 wherein the forming step includes the step of using an inverse Fourier transform on the series of magnitude images to regenerate k-space data as k-space matrices, where the k-space data are idealized representations in that they do not contain any phase information pertaining to velocity.

5. The method as described in Claim 4 wherein the forming step includes the steps of arranging the k-space matrices in ascending temporal order and Fourier transforming the k-space matrices along a temporal axis, resulting in a series of Fourier coefficients.

6. The method as described in Claim 5 wherein the Fourier transforming step includes the step of applying the Fourier transform to a time domain of the k-space matrices which generates a series of k-space data, which includes a first zeroth-order Fourier coefficient and higher order Fourier coefficients, that contain information relating to a spatial distribution and velocity of the pixels.

7. The method as described in Claim 6 wherein the Fourier transforming step includes the steps of applying the Fourier transform to a time-ordered series of the k-space matrices corresponding to each frame of a time series to generate a second zeroth-order Fourier coefficient and higher order Fourier coefficients.

8. The method as described in Claim 7, including the step of replacing the second zeroth-order Fourier coefficient with the first zeroth-order Fourier coefficient, and applying the Fourier transform to ordered composite Fourier coefficients to generate k-space data that are individually Fourier transformed to generate images where the phase of the images represents the velocity data for each pixel.

9. The method as described in Claim 8 including the step of applying imaging gradients and radiofrequency transition pulses to the moving portion of the patient to obtain the k-space data.

10. The method as described in Claim 9 including the steps of converting electrical voltage signal information from the patient into digital values with the detector coils, and storing the digital values along with information regarding which k-space lines were acquired into the memory.

11. The method as described in Claim 10 including the steps of altering the gradient strengths produced by the imaging coils to obtain data at a next k-space position, and reapplying the imaging gradients and radiofrequency transition pulses to the moving portion of the patient.

12. An MRI comprising:
a computer;
imaging coils in communication with the computer that apply imaging gradients and radiofrequency transition pulses to a moving portion of the patient;
detector coils in communication with a computer that obtain a single image component series representing velocity information of the moving portion of the patient in k-space of one cardiac cycle; and
a memory in communication with the detector coils in the computer which stores the single image component series, the computer forming an image from the single image component series stored in the memory without any comparison of any image component of the series.

13. The MRI as described in Claim 12 wherein the computer extracts a velocity component of phase information on each image component.

14. The MRI as described in Claim 13 wherein the computer uses a magnitude Fourier transform such that no phase information is calculated for each pixel of each image component of the series to create a series of magnitude images from the single image component series.

15. The MRI as described in Claim 14 wherein the computer uses an inverse Fourier transform on the series of magnitude images to regenerate k-space data as k-space matrices, where the k-space data are idealized representations in that they do not contain any phase information pertaining to velocity.

16. The MRI as described in Claim 15 wherein the computer arranges the k-space matrices in ascending temporal order and Fourier transforms the k-space matrices along a temporal axis, resulting in a series of Fourier coefficients.

17. The MRI as described in Claim 16 wherein a zeroth coefficient of the Fourier coefficients represents an average of the series of k-space matrices, and other coefficients of the Fourier coefficients operate on the zeroth coefficient with the computer to form a data set whereby the zeroth coefficient data oscillate in a manner determined by the frequency of each higher coefficient represented.

18. The MRI as described in Claim 17 wherein the computer applies imaging gradients and radiofrequency transition pulses to the moving portion of the patient to obtain the k-space data.

19. The MRI as described in Claim 18 wherein the computer converts electrical voltage signal information from the patient into digital values with the detector coils, and storing the digital values along with information regarding which k-space lines were acquired into the memory.

20. The MRI as described in Claim 19 wherein the computer alters the gradient strengths produced by the imaging coils to obtain data at a next k-space position, and reapplies the imaging gradients and radiofrequency transmission pulses to the moving portion of the patient.

21. A method for using an MRI with a patient comprising the steps of:
obtaining a single image component series representing velocity information of at least a portion of a moving portion of a cardiovascular system of the patient in k-space of one cardiac cycle with imaging coils and detector coils of the MRI; and
forming with a computer of the MRI an image from the single image component series stored in a memory without any comparison of any image component of the series.

22. An MRI comprising:
a computer;
imaging coils in communication with the computer that apply imaging gradients and radiofrequency transition pulses to a moving portion of at least a portion of a cardiovascular system of the patient;
detector coils in communication with a computer that obtain a single image component series representing velocity information of the moving portion of the patient in k-space of one cardiac cycle; and
a memory in communication with the detector coils in the computer which stores the single image component series, the computer forming an image from the single image component series stored in the memory without any comparison of any image component of the series.
